(19) **Europäisches Patentamt / European Patent Office / Office européen des brevets**

(11) **EP 3 807 595 B1**

(12) **FASCICULE DE BREVET EUROPEEN**

(45) Date de publication et mention
de la délivrance du brevet:
**02.04.2025 Bulletin 2025/14**

(21) Numéro de dépôt: **19745680.9**

(22) Date de dépôt: **12.06.2019**

(51) Classification Internationale des Brevets (IPC):
**G01C 17/38** *(2006.01)*     **G01C 21/16** *(2006.01)*
**G01C 25/00** *(2006.01)*     **G01C 21/08** *(2006.01)*

(52) Classification Coopérative des Brevets (CPC):
**G01C 25/005; G01C 17/38; G01C 21/08;
G01C 21/1654**

(86) Numéro de dépôt international:
**PCT/FR2019/051415**

(87) Numéro de publication internationale:
**WO 2019/239063 (19.12.2019 Gazette 2019/51)**

(54) **PROCÉDÉ DE CALIBRATION D'UN GYROMÈTRE ÉQUIPANT UN OBJET**

VERFAHREN ZUM KALIBRIEREN EINES IN EINEM OBJEKT EINGEBAUTEN GYROMETERS

METHOD FOR CALIBRATING A GYROMETER FITTED IN AN OBJECT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.06.2018 FR 1855169**

(43) Date de publication de la demande:
**21.04.2021 Bulletin 2021/16**

(73) Titulaire: **SYSNAV
27200 Vernon (FR)**

(72) Inventeurs:
- **VISSIERE, David
  75009 Paris (FR)**
- **HILLION, Mathieu
  27200 Vernon (FR)**
- **MEIER, Hendrik
  27200 Vernon (FR)**

(74) Mandataire: **Regimbeau
20, rue de Chazelles
75847 Paris Cedex 17 (FR)**

(56) Documents cités:
**FR-A1- 2 914 739      US-A1- 2012 259 572
US-A1- 2014 202 229      US-A1- 2014 336 970**

**Description**

DOMAINE TECHNIQUE GENERAL

La présente invention concerne le domaine de la navigation sans GNSS.

Plus précisément, elle concerne un procédé de calibration d'un gyromètre solidaire de magnétomètres.

ETAT DE L'ART

Il est aujourd'hui commun de suivre la position d'un véhicule par GNSS (Global Navigation Satellite System, par exemple le GPS) ou en utilisant un réseau de communication sans fil (triangulation à l'aide de bornes émettrices, réseau wifi ou autres).

Ces méthodes s'avèrent très limitées car elles ne permettent pas d'assurer disponibilité et précision de l'information, l'une et l'autre étant affectées par d'éventuels masquages entre les sources et le récepteur. Elles s'avèrent également dépendantes de technologies extérieures comme les satellites pour le GNSS qui peuvent être indisponibles voire volontairement brouillées.

Alternativement, on connait aussi des méthodes « autonomes » pour suivre dans n'importe quel environnement le déplacement relatif d'un véhicule grâce par exemple à une centrale inertielle ou magnéto-inertielle. Par déplacement relatif, on entend la trajectoire du véhicule dans l'espace par rapport à un point et à un repère donnés à l'initialisation. En plus de la trajectoire, ces méthodes permettent également d'obtenir l'orientation du véhicule par rapport au même repère initial.

Une centrale inertielle de classe navigation est constituée au minimum de trois accéléromètres et de trois gyromètres disposés en triaxe. Typiquement, les gyromètres « maintiennent » un repère, dans lequel une double intégration temporelle des mesures des accéléromètres permet d'estimer le mouvement.

Il est notablement connu que pour pouvoir utiliser les méthodes de navigation inertielle classique, telles que mises en œuvre dans les applications lourdes comme la navigation des avions de chasse ou de ligne, des sous-marins, des navires, etc., il est nécessaire d'utiliser des capteurs de très haute précision. En effet la double intégration temporelle d'une mesure d'accélération fait qu'une erreur constante d'accélération crée une erreur de position qui augmente de façon proportionnelle au carré du temps.

Alternativement, il est connu que si l'information de vecteur vitesse dans le repère du porteur peut être fournie par une source externe (odométrie sur une voiture, loch sur un navire, tube de Pitot sur un avion), il est possible d'obtenir la trajectoire du porteur dès lors que l'on est en capacité de connaître son orientation et notamment son cap.

Dans un certain nombre de cas, le cap initial est connu (« alignement » initial d'un dispositif inertiel) et peut être obtenu par des capteurs autres qu'inertiels (par exemple magnétiques) ou déduit directement des capteurs inertiels lorsque ceux-ci permettent de mesurer précisément la rotation terrestre.

La difficulté si l'on souhaite travailler avec des capteurs bas coût est d'« augmenter » leur performance en calibrant en continu leurs paramètres d'erreur, de sorte à maintenir au mieux l'information d'orientation d'un porteur, en particulier l'information de cap sur un véhicule terrestre.

Il a par conséquent été proposé dans ce contexte de calibrer un gyromètre grâce à des mesures magnétiques.

La demande US2012/0116716 propose de regarder si l'évolution d'un champ magnétique entre deux points de mesure correspond au changement de l'attitude prédite par l'intégration des gyromètres. Elle fait cependant l'hypothèse que les mesures magnétométriques/accélérométriques sont fiables, ce qui est délicat. En effet, on constate en pratique que :

- le champ magnétique ambiant n'est pas toujours homogène et stationnaire ;
- les éléments métalliques (par exemple une carrosserie) ou aimants à proximité ont un impact sur la mesure magnétique (effets de type fer doux et fer dur), voir également la demande US2004/0123474.
- Pour calibrer correctement un magnétomètre, il est nécessaire de le mettre dans un maximum d'orientation spatiale de manière à « exciter le modèle d'erreur » pour avoir de l'observabilité. Ce problème est facilement soluble pour un équipement qu'on peut porter à la main et qu'on peut ainsi tourner dans tous les sens, voir par exemple la demande FR1757082, avant de s'en servir. Si au contraire le magnétomètre équipe un véhicule, on est contraint :

  ○ par le fait que lors d'un trajet typique d'un véhicule, roulis et tangage ne dévient de zéro que faiblement.
  ○ par le fait que la caisse s'aimante, ou bien qu'on a chargé le véhicule, ce qui fait que la calibration peut n'être plus pertinente; ce qui va nécessiter des recalibrations régulières.

La demande US2011/0178707 concerne plus précisément les dispositifs de type smartphone comprenant une boussole magnétique et un gyromètre, et évoque le problème des perturbations magnétiques. Cette demande vise plutôt la calibration de la boussole magnétique à partir des données gyrométriques, mais propose également l'inverse (i.e. la calibration d'un gyromètre à partir de données magnétiques), en prenant quant à elle comme point de départ un quaternion $q$ magnéto-accélérométrique et en obtenant la vitesse angulaire de recalage à partir de ce quaternion $\omega = 2q^{-1}\dot{q}$. Cependant, il est toujours fait l'hypothèse que les mesures magnétométriques/accélérométriques sont fiables, et dans le cas contraire il est juste proposé soit de ne pas mettre à jour le biais du gyromètre tant que cette situation dure, soit d'utiliser un quaternion par défaut stocké dans une mémoire.

Le document US 2012/259572 A1 divulgue un procédé de calibration d'un gyromètre qui mesure une vitesse angulaire d'un objet évoluant dans un champ magnétique ambiant, le procédé utilisant des moyens de mesure magnétique solidaires dudit objet pour mesurer au moins deux composantes du champ magnétique et déterminant par des moyens de traitement de données des valeurs d'au moins un paramètre de calibration du gyromètre minimisant une expression définie par une vitesse angulaire estimée de l'objet et une équation magnétique sur les composantes du champ magnétique, le procédé détectant une condition de stationnarité et d'uniformité du champ magnétique pour calibrer le gyromètre.

Il serait souhaitable de disposer d'une nouvelle méthode de calibration d'un gyromètre d'un objet en vue de l'estimation du mouvement de cet objet qui permette une excellente qualité de résultat et ne soit pas contraignante.

PRESENTATION DE L'INVENTION

La présente invention se rapporte ainsi selon un premier aspect à un procédé de calibration d'un gyromètre équipant un objet évoluant dans un champ magnétique ambiant, comprenant les étapes a), b), c) et d) selon la revendication indépendante 1.

Selon d'autres caractéristiques avantageuses et non limitatives :

- la vitesse angulaire estimée $\omega_{gyro}^{(estimation)}$ de l'objet est liée à la vitesse angulaire mesurée $\omega_{gyro}^{(mesure)}$ par un modèle $\omega_{gyro}^{(estimation)} = D \cdot \left(\omega_{gyro}^{(mesure)} + b_{gyro}\right)$, où $D$ et $b_{gyro}$ sont les paramètres de calibration du gyromètre ;

- le procédé comprend une étape (e) de nouvelle estimation dudit paramètre représentatif d'une erreur sur les paramètres de calibration ;

- ledit paramètre représentatif d'une erreur sur les paramètres de calibration est fonction de la valeur de ladite première expression, ou le cas échéant de ladite deuxième expression, calculée pour les valeurs déterminées des paramètres de calibration ;

- l'étape (c), et le cas échéant l'étape (e), comprend la détermination d'un intervalle d'erreur accumulée en fonction de la valeur dudit paramètre représentatif d'une erreur sur les paramètres de calibration et d'une durée depuis la dernière calibration du gyromètre, ledit seuil prédéterminé dépendant dudit intervalle d'erreur accumulée ;

- les composantes du champ magnétique et/ou d'une dérivée i-ième du champ magnétique acquises à l'étape (a) sont des composantes mesurées, et celles utilisées par lesdites première et deuxième équations magnétiques sont des composantes estimées en fonction des composantes mesurées et de paramètres de calibration des moyens de mesure magnétique, l'étape (b) et, le cas échéant l'étape (d), comprenant également la détermination de valeurs d'au moins un paramètre de calibration des moyens de mesure magnétique ;

- les moyens de mesure magnétique sont des magnétomètres triaxes, les composantes estimées $M^{(estimation)}$ du champ magnétique étant liées aux composantes mesurées $M^{(mesure)}$ par un modèle $M^{(mesure)} = A \cdot M^{(estimation)} + b_{magneto}$, où $A$ et $b_{magneto}$ sont les paramètres de calibration des moyens de mesure magnétique ;

- la ou les premières équations magnétiques sont de la forme $\dot{\nabla_n M} = f_n(\omega) \times \nabla_n M$, et le cas échéant la ou les deuxièmes équations magnétiques sont de la forme $\dot{\nabla_n M} = f_n(\omega) \times \nabla_n M + g_n(\nabla_{n+1} M).V$ où $\nabla_n M$ est une dérivée n-ième du champ magnétique, $\omega$ la vitesse angulaire, $V$ la vitesse linéaire, et $f_n$ et $g_n$ des fonctions prédéterminées ;

- la première expression est fonction de $\left| \dot{\nabla_n M^{(estimation)}} - f_n\left(\omega_{gyro}^{(estimation)}\right) \times \nabla_n M^{(estimation)} \right|$ et la deuxième expression est fonction de $\left| \dot{\nabla_n M^{(estimation)}} - f_n\left(\omega_{gyro}^{(estimation)}\right) \times \nabla_n M^{(estimation)} - g_n\left(\nabla_{n+1} M^{(estimation)}\right).V \right|$.

- ledit paramètre représentatif d'une erreur sur les paramètres de calibration est soit la moyenne de

$$\left|\nabla_{\mathrm{n}}M^{(estimation)} - f_n\left(\omega_{gyro}^{(estimation)}\right) \times \nabla_{\mathrm{n}}M^{(estimation)}\right|^2 \quad \text{ou}$$

$$\left|\nabla_{\mathrm{n}}M^{(estimation)} - f_n\left(\omega_{gyro}^{(estimation)}\right) \times \nabla_{\mathrm{n}}M^{(estimation)} - g_n\left(\nabla_{\mathrm{n+1}}M^{(estimation)}\right).V\right|^2 \quad \text{sur}$$

un intervalle de temps donné, soit tout ou partie d'un gradient spatial desdites composantes du champ magnétique et/ou d'une dérivée i-ième du champ magnétique ;

- le procédé comprend une étape (f) d'estimation par les moyens de traitement de données du mouvement dudit objet (1) en fonction de la vitesse angulaire mesurée de l'objet, des composantes du champ magnétique et/ou d'une dérivée i-ième du champ magnétique, et/ou de l'éventuelle vitesse linéaire mesurée de l'objet, et des valeurs des paramètres de calibration, dans lequel une orientation du véhicule est estimée à l'étape (f) uniquement en fonction de la vitesse angulaire mesurée du véhicule et des valeurs des paramètres de calibration.

Selon un deuxième aspect, est proposé un objet évoluant dans un champ magnétique ambiant, comprenant un gyromètre configuré pour acquérir une vitesse angulaire mesurée de l'objet, selon la revendication indépendante 13.

Selon d'autres caractéristiques avantageuses et non limitatives :

• L'objet est un véhicule à roues, les moyens d'acquisition supplémentaire étant au moins deux odomètres équipant des roues du véhicule.

Selon un troisième aspect, il est proposé un produit programme d'ordinateur, selon la revendication 14, comprenant des instructions de code pour l'exécution d'un procédé selon le premier aspect de l'invention de calibration d'un

PRESENTATION DES FIGURES

D'autres caractéristiques et avantages de la présente invention apparaîtront à la lecture de la description qui va suivre d'un mode de réalisation préférentiel. Cette description sera donnée en référence aux dessins annexés dans lesquels :

- la figure 1 représente un exemple d'architecture de véhicule pour la mise en œuvre du procédé selon l'invention ;
- la figure 2 est un diagramme représentant les étapes d'un mode de réalisation préféré du procédé selon l'invention.

DESCRIPTION DETAILLEE

*Architecture*

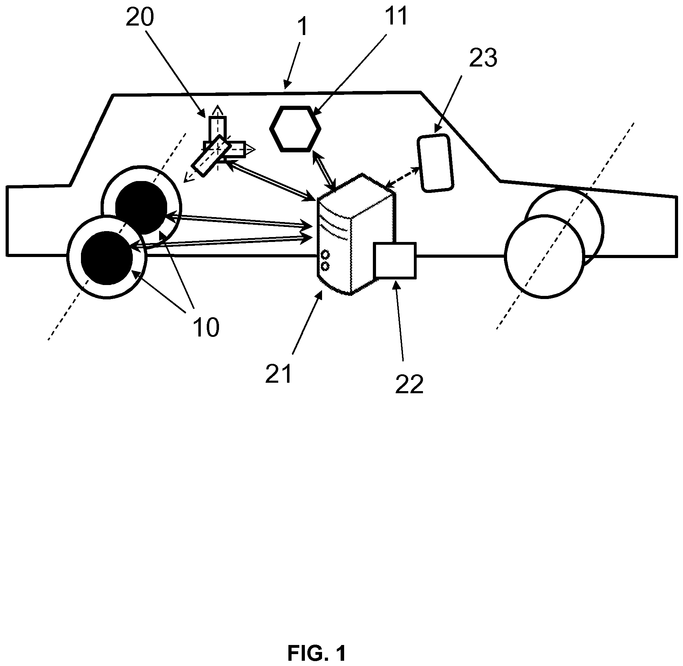

En référence à la **figure 1**, le présent procédé permet la calibration d'un gyromètre 11 d'un objet 1 évoluant dans un champ magnétique ambiant (typiquement le champ magnétique terrestre, le cas échéant altéré par les objets métalliques à proximité), noté *M*. Comme déjà expliqué, le champ magnétique est un champ vectoriel en l'espèce tridimensionnel, c'est-à-dire associant un vecteur de dimension trois à chaque point de tridimensionnel dans lequel l'objet 1 est mobile.

Cet objet 1 peut être n'importe quel objet mobile dont la connaissance de la position est souhaitée, par exemple un véhicule, en particulier un véhicule à roues, un drone, etc., mais également une personne ou une partie du corps de cette personne (ses mains, sa tête, etc.).

L'objet 1 est équipé du gyromètre 11 et de moyens de mesure magnétique 20. Les moyens 20 et le gyromètre 11 sont solidaires de l'objet 1, par exemple solidaires de la carrosserie dans le cas d'un véhicule, et de façon générale fixes dans le repère de l'objet 1.

Les moyens de mesure magnétique 20 sont typiquement des magnétomètres et/ou des gradiomètres magnétiques. Dans ce dernier cas, au lieu de mesurer la valeur des composantes du champ magnétique M, les gradiomètres mesurent directement la valeur des composantes du gradient du champ magnétique *M*, i.e. la valeur des dérivées spatiales (éventuellement en plus du champ magnétique). De tels gradiomètres magnétiques 20 sont connus de l'homme du métier. Selon certains modes de réalisation de l'invention, on pourra utiliser des gradiomètres mesurant directement la valeur des dérivées secondes (gradient d'ordre deux), et de façon générale des dérivées i-ièmes (gradient d'ordre *i*).

Dans la suite de la description on prendra l'exemple de magnétomètres mais l'homme du métier saura transposer à des gradiomètres.

Le ou les magnétomètres 20 sont préférentiellement « axiaux », c'est à dire capables de mesurer une composante dudit champ magnétique, i.e. la projection dudit vecteur champ magnétique *M* selon leur axe (ou, dans le cas d'un gradiomètre, une composante d'une dérivée spatiale d'ordre *i* dudit champ magnétique, i.e. la variation d'une composante de $\nabla^{i-1}M$ au niveau du gradiomètre selon son axe).

Les magnétomètres 20 sont au moins au nombre de deux, et préférentiellement au moins au nombre de trois, de sorte à pouvoir acquérir respectivement au moins deux ou trois composantes du champ magnétique. On comprendra en effet que deux magnétomètres peuvent suffire, s'ils sont disposés orthogonalement l'un par rapport à l'autre dans un plan orthogonal à l'axe de rotation vertical du véhicule, i.e. un plan horizontal. Néanmoins, utiliser trois magnétomètres 20 et acquérir trois composantes permet de s'affranchir de la nécessité de cette disposition particulière.

Avantageusement les magnétomètres 20 sont même d'un nombre supérieur à trois, comme six voire même neuf, avantageusement organisés par groupes de trois en « triaxes », i.e. un triplet de magnétomètres 20 deux à deux orthogonaux associés à une même position spatiale et mesurant le champ magnétique selon les trois axes (dans le cas de six magnétomètres 20 on a deux triaxes et dans le cas de neuf magnétomètres 20 on a trois triaxes). Deux triaxes permettent de mesurer le champ magnétique ainsi qu'une partie de son gradient (voir plus loin), et à partir de huit magnétomètres 20 qui ont été convenablement positionnés et orientés, on peut déterminer toutes les composantes du gradient. Ceci est par exemple le cas pour trois triaxes positionnés aux coins d'un triangle rectangulaire isocèle.

De façon préférée, le repère orthonormé associé à l'objet est choisi par convention (et par facilité pour la suite de la présente description) tel que les triaxes sont avantageusement orientés conformément audit repère orthonormé, de sorte à faciliter encore les calculs.

Mais l'homme du métier saura dans tous les cas transposer à n'importe quelle disposition spatiale de magnétomètres/gradiomètres.

Par gyromètre 11, on entend des moyens de mesure inertielle aptes à mesurer la vitesse angulaire de l'objet 1 selon un système de trois axes orthogonaux, qui définissent le repère de l'objet 1, i.e. mesurer les trois composantes d'une vecteur vitesse angulaire noté ω. On comprend ainsi que le gyromètre 11 peut en fait désigner un ensemble de trois gyromètres associés à un des trois axes, en particulier en triaxe (i.e. chacun apte à mesure une des trois composantes du vecteur vitesse angulaire noté ω).

Dans le mode de réalisation préféré où l'objet 1 est un véhicule, ce repère comporte préférentiellement un axe vertical et deux axes horizontaux, en particulier un axe longitudinal et un axe transversal. La rotation autour de l'axe vertical du véhicule est décrite par l'angle sur lequel le conducteur agit en tournant le volant. Sur un sol généralement plat, les changements de direction du véhicule sont dans le plan horizontal, i.e. également selon ledit axe vertical du lacet. En réalité, des valeurs non-nulles pour le roulis (rotation selon l'axe longitudinal du véhicule) et le tangage (rotation selon l'axe transversal du véhicule) peuvent être le résultat par exemple d'une route en pente mais sont typiquement faibles.

Le procédé objet de la présente invention permet de calibrer les trois composantes du vecteur vitesse angulaire ω.

L'objet 1 est en outre équipé de moyens d'acquisition « supplémentaires » 10 d'une vitesse linéaire mesurée de l'objet 1 (notée V), c'est-à-dire du déplacement. Ces moyens 10 peuvent directement ou indirectement permettre d'obtenir la vitesse linéaire, et ainsi être de nombreux types, par exemple des moyens de mesure inertielle. Ainsi le gyromètre 11 peut être complété par un ou plusieurs accéléromètres, voire l'objet 1 peut comprendre une centrale à inertie « 6 axes ». Les accéléromètres sont sensibles aux forces extérieures autres que gravitationnelles appliquées sur le capteur, et permettent de mesurer une accélération spécifique notée γ.

Alternativement, les moyens 10 peuvent consister, si l'objet 1 est un véhicule à roues, en au moins deux odomètres chacun pour une roue du véhicule, par exemple les deux roues arrière, comme cela est représenté dans l'exemple de la **figure 1**. On note qu'un ensemble d'odomètres est un moyen simple et fiable d'obtenir une simple vitesse linéaire.

Par odomètre en entend un équipement capable de mesurer la vitesse d'une roue en comptant les tours (« compte-tours »). Généralement, les odomètres présentent une partie fixée à la roue (par exemple un aimant), et détectent chaque passage de cette partie fixée (appelé « top ») de sorte à compter le nombre de tours par unité de temps, qui est la fréquence de rotation. On connait d'autres techniques, par exemple la détection optique d'une marque sur la roue, ou le magnétomètre du brevet FR2939514 qui détecte la rotation d'un objet métallique tel qu'une roue.

Ici la « vitesse » d'une roue est un scalaire, i.e. la norme de la vitesse de la roue dans le référentiel terrestre (dans l'hypothèse d'absence de dérapage). Si le rayon *r* de la roue est connu, la mesure de la fréquence *f* de rotation permet d'estimer cette norme de la vitesse : $v=2\pi rf$.

Encore alternativement, les moyens supplémentaires 10 peuvent être un récepteur GNSS. On comprendra que l'homme du métier n'est limité à aucune technique particulière pour la mesure de vitesse.

L'objet 1 comprend en outre comme expliqué des moyens de traitement 21 (typiquement un processeur) pour la mise en œuvre, en particulier en temps réel, des traitements du présent procédé, par exemple un ordinateur de bord d'un véhicule, et éventuellement une mémoire 22 et une interface 23 pour restituer des informations du mouvement de l'objet 1 (une valeur de vitesse instantanée, un cap, une position sur une carte, etc.), et/ou envoyer des commandes à l'objet 1. L'objet 1 peut à ce titre être notamment un véhicule autonome, et les moyens de traitement 21 configurés pour mettre en œuvre la navigation autonome du véhicule. Ainsi, lesdites commandes sont envoyées aux organes de contrôle du véhicule (moteur, actionneurs du volant, etc.) de sorte à simuler la conduite par le conducteur.

A noter que les moyens de traitement 21 peuvent être externes à l'objet 1, et par exemple connectés à ces derniers par un réseau sans fil. Alternativement, le gyromètre 11 et les moyens de mesure magnétique 20 peuvent être connectés aux moyens de traitement de données 21 de manière filaire, par exemple via Ethernet.

*Procédé*

Le procédé objet de la présente invention est un procédé de calibration d'au moins le gyromètre 11. Par calibration, on entend la détermination d'un ou plusieurs paramètres de calibration, dont on verra une liste plus loin. En particulier, certains paramètres de calibrations peuvent être considérés fiables et prédéterminés, et d'autres à déterminer. En ce qui concerne ceux à déterminer, on peut prévoir qu'ils présentent des valeurs « actuelles » (en d'autres termes qu'une calibration a déjà eu lieu), et que ces valeurs vont le cas échéant être modifiées (en cas de nouvelle calibration).

Dans un mode de réalisation particulièrement préféré, le procédé peut en outre être un procédé de calibration des moyens de mesure magnétique 20, i.e. le gyromètre 11 et les magnétomètres 20 peuvent être calibrés simultanément. Il s'agit d'un mode extrêmement avantageux, puisque comme l'on verra il n'y a même plus besoin de supposer que l'une de la gyrométrie (les données gyrométriques) et de la magnétométrie (les données magnétiques) est fiable pour l'utiliser comme référence pour calibrer l'autre : les deux se calibrent automatiquement l'une l'autre. Alternativement, il sera bien entendu possible de considérer les magnétomètres 20 comme bien calibrés et de calibrer le gyromètre 11 en conséquence, ce qui permet par exemple de calibrer plus de paramètres du gyromètre 11.

Comme l'on verra, dans un mode de réalisation avantageux le présent procédé est même un procédé d'estimation du mouvement de l'objet 1, i.e. il comprend suite à la calibration l'utilisation des mesures pour en déduire de façon fiable une ou plusieurs composantes du mouvement.

Dans une première étape (a), le procédé comprend l'acquisition par le gyromètre 11 d'une vitesse angulaire mesurée de l'objet 1, notée $\omega_{gyro}^{(mesure)}$, et par les moyens de mesure magnétique 20, d'au moins deux composantes du champ magnétique et/ou d'une dérivée i-ième du champ magnétique. Ces composantes sont plus précisément des composantes dites mesurées, formant un vecteur noté $M^{(mesure)}$ dans le cas du champ magnétique (dans le cas d'une dérivée i-ème, on pourra noter $\nabla_i M^{(mesure)}$). De façon préférée, on acquiert trois composantes de la vitesse angulaire et au moins six voire huit composantes magnétiques (avantageusement deux voire trois triaxes magnétométriques positionnés aux coins d'un triangle rectangulaire isocèle), de sorte à pouvoir en déduire le champ et au moins une partie de son gradient (i.e. les dérivées à l'ordre suivant selon les trois axes).

Ces grandeurs sont avantageusement mesurées avec un échantillonnage dt (i.e. toutes les « dt » secondes) avec dt très petit devant le temps caractéristique des mouvements de l'objet 1, typiquement 40 ms.

Dans une étape (b), les moyens de traitement de données 21 déterminent les valeurs d'au moins un paramètre de calibration du gyromètre 11 minimisant une première expression définie par une vitesse angulaire estimée de l'objet 1 et au moins une première équation magnétique sur les composantes du champ magnétique et/ou d'une dérivée i-ième du champ magnétique.

L'idée est d'estimer séparément des données gyrométriques et des données magnétiques qui sont théoriquement liées par une équation magnétique. Ainsi, grâce à l'équation, on peut exprimer une quantité qui idéalement devrait être nulle (i.e. les données gyrométriques et magnétiques vérifient exactement l'équation magnétique), sinon c'est que la calibration est à parfaire.

La vitesse angulaire estimée de l'objet 1, notée $\omega_{gyro}^{(estimation)}$, est fonction de la vitesse angulaire mesurée et de paramètres de calibration du gyromètre 11, i.e. en général $\omega_{gyro}^{(estimation)} = g(\omega_{gyro}^{(mesure)})$ avec $g$ une fonction (application) qui est déterminée par les paramètres de calibration. Au cas le plus simple, $g$ est affine et $\omega_{gyro}^{(estimation)}$ est liée à la vitesse angulaire mesurée $\omega_{gyro}^{(mesure)}$ par une formule du type $\omega_{gyro}^{(estimation)} = D \cdot (\omega_{gyro}^{(mesure)} - b_{gyro})$, où $D$ et $b_{gyro}$ représentent les paramètres de calibration du gyromètre 11.

Dans le cas d'une attitude tridimensionnelle, $b_{gyro}$ est un vecteur de biais et $D$ est une matrice 3x3 = (matrice orthogonale de passage au bon repère) $\times$ (matrice triangulaire supérieure contenant les facteurs d'échelle et les calages). De façon simplifiée, on peut par exemple considérer que $D$ est prédéterminée (elle varie en pratique très lentement) et que le seul paramètre de calibration à déterminer pour le gyromètre 11 est $b_{gyro}$, qui a effectivement tendance à varier dans le temps (on parle de dérive du gyromètre 11).

Comme expliqué, les composantes du champ magnétique et/ou d'une dérivée i-ième du champ magnétique acquises à l'étape (a) sont préférentiellement des composantes mesurées (i.e. potentiellement biaisées), et celles utilisées par ladite première équation magnétiques sont des composantes estimées (le vecteur correspondant est noté $M^{(estimation)}$ dans le cas du champ magnétique - dans le cas d'une dérivée i-ème, on pourra noter $\nabla_i M^{(estimation)}$), en fonction des composantes mesurées et de paramètres de calibration des moyens de mesure magnétique 20.

Dans le cas où les moyens de mesure magnétique 20 sont des magnétomètres (i.e. on travaille sur les composantes du champ magnétique et pas une dérivée), les composantes estimées $M^{(estimation)}$ du champ magnétique sont avantageusement liées aux composantes mesurées $M^{(mesure)}$ par un modèle de la forme $M^{(mesure)} = A \cdot M^{(estimation)} + b_{magneto}$, où la matrice 3x3 $A$ et le vecteur $b_{magneto}$ sont les paramètres de calibration des moyens de mesure magnétique 20. Dans la mesure où c'est plutôt la composante estimée qu'on souhaite exprimer en fonction de la composante mesurée, on peut écrire $M^{(estimation)} = A^{-1} \cdot (M^{(mesure)} - b_{magneto})$.

$b_{magneto}$ est généralement représentatif des effets « type fer dur», et la matrice A représentative des effets « type fer doux ». Ces effets correspondent aux effets fer dur/doux à proprement parler mais peuvent aussi inclure des phénomènes avec le même impact mais une cause différente (par exemple des effets dus à l'électronique/la physique du magnétomètre 20).

Comme pour le gyromètre, plus généralement, on peut regarder un modèle d'erreur général : $M^{(estimation)} = h(M^{(mesure)})$ avec $h$ une fonction (application) qui n'est pas nécessairement affine.

Dans le cas affine ($M^{(mesure)} = A \cdot M^{(estimation)} + b_{magneto}$), $A$ est une matrice $3 \times 3$, que l'on peut écrire comme $A = R \cdot \tilde{A}$ avec $R$ orthogonale et $\hat{A}$ triangulaire supérieure.

A noter qu'on suppose que les moyens de mesure magnétique 20 en eux-mêmes sont *a priori* parfaitement calibrés, ce n'est que leur environnement direct (carrosserie, etc.) qui doit être corrigé en calibration afin de pouvoir estimer le champ magnétique terrestre que l'on mesurerait en absence de l'objet 1. La matrice $R$ est ainsi importante et à déterminer en sorte que le repère magnétique objet reste stable.

Les méthodes classiques de calibration par rapport à des sphères ne déterminent $R$ qu'à une rotation autour d'un axe près (voir le document E. Dorveaux, D. Vissière, A. P. Martin, N. Petit, "Iterative calibration method for inertial and magnetic sensors", in Proc. of the 48th IEEE Conf. on Decision and Control 2009). Les axes capteurs ne restent pas fixes après l'application de ces méthodes.

On peut en pratique déterminer huit coefficients de $A$ en calibration (un coefficient, le facteur d'échelle global qui relie la mesure à l'unité physique en Tesla (ou Gauss), ne peut pas être déterminé, mais en même temps, il n'est pas nécessaire de le connaître pour calibrer le gyromètre 11).

Ainsi, dans le mode de réalisation particulièrement préféré de double calibration simultanée, il n'y a que trois paramètres de calibration à déterminer : $b_{gyro}$, $A$ et $b_{magneto}$. Ce nombre restreint de paramètres rend possible une telle double calibration dès lors que l'objet 1 présente une trajectoire « variée » (directions / vitesses qui présentent une grande diversité de valeurs en fonction du temps).

*Equation magnétique*

L'évolution du champ magnétique dans le repère de l'objet 1 (dit *body*) au cours du temps est décrite par l'équation

$$\dot{M} = -\omega \times M + \nabla M \cdot V + \frac{\partial M}{\partial t}.$$

Le premier terme $-\omega \times M$ décrit le changement du champ dans le repère de l'objet 1 qui est dû à la rotation de ce repère par rapport au repère fixe. Le deuxième terme $\nabla M \cdot V$ décrit le changement du champ mesuré issu du mouvement dans une région avec un champ inhomogène. Finalement, le troisième terme $\frac{\partial M}{\partial t}$ prend en compte les instationnarités du champ magnétique (par exemple les courants périodiques tels que le 50 Hz en Europe, des mouvements d'un aimant/un objet en acier à proximité dudit objet, etc.).

S'il n'y a pas de perturbation magnétique « mobile », i.e. le champ magnétique présente un caractère stationnaire, $\frac{\partial M}{\partial t} \approx 0$, et on peut réduire l'équation à $\dot{M} = -\omega \times M + \nabla M \cdot V$.

S'il n'y a pas de perturbation magnétique du tout, i.e. le champ magnétique présente un caractère uniforme en plus de stationnaire, $\nabla M \approx 0$ et on peut encore réduire l'équation à $\dot{M} = -\omega \times M$.

Dans le cas d'une utilisation de capteurs magnétiques pour déterminer un cap, cette double hypothèse d'uniformité et stationnarité est le plus souvent vérifiée ou supposée (comme lorsqu'on utilise une boussole). En effet, pour le champ magnétique terrestre, l'uniformité est localement constatée en très bonne approximation dans nos latitudes, hors les cas de présence par exemple d'une structure métallique ou en béton armé (typiquement un pont) dans les alentours. Les instationnarités dues à des déplacements d'objets à proximité sont encore plus rares car il faudrait que les sources de perturbations se déplacent, et les éventuelles instationnarités dues à des courant périodiques sont en moyenne nulle et peuvent aussi être traitées avec des techniques d'estimation, voir par exemple document C.-I. Chesneau, M. Hillion, and C. Prieur, Motion estimation of a Rigid Body with an EKF using Magneto-Inertial Measurements, 7th Conf. on Indoor Positioning and Indoor Navigation (IPIN'16), Madrid, Spain, 2016.

On note qu'on connait la possibilité de généraliser les équations magnétiques (réduites ou non), de sorte à lier non pas les variations spatiales et temporelles du champ magnétique évaluées grâce aux mesures de magnétomètres, mais les variations spatiales et temporelles des gradients magnétiques (i.e. les variations spatiales du champ magnétique) évaluées en particulier grâce aux mesures de gradiomètres. Plus précisément, l'équation $\dot{M} = -\omega \times M + VM \cdot V$ se dérive en $\nabla_{\mathrm{n}}\dot{M} = f_n(\omega).\nabla_{\mathrm{n}}M + g_n(\nabla_{\mathrm{n+1}}M).V$, avec $n + 1 \geq i \geq 1$, où $\nabla_{\mathrm{n}}M$ est une dérivée n-ième du champ magnétique, et $f_n$ et $g_n$ des fonctions prédéterminées, voir la demande FR1756675.

Dans la suite de la présente description, on utilisera par commodité les équations à l'ordre 0 (c'est-à-dire basées sur $\dot{M} = -\omega \times M + \nabla M \cdot V$), mais l'homme du métier saura transposer le procédé aux ordres supérieurs.

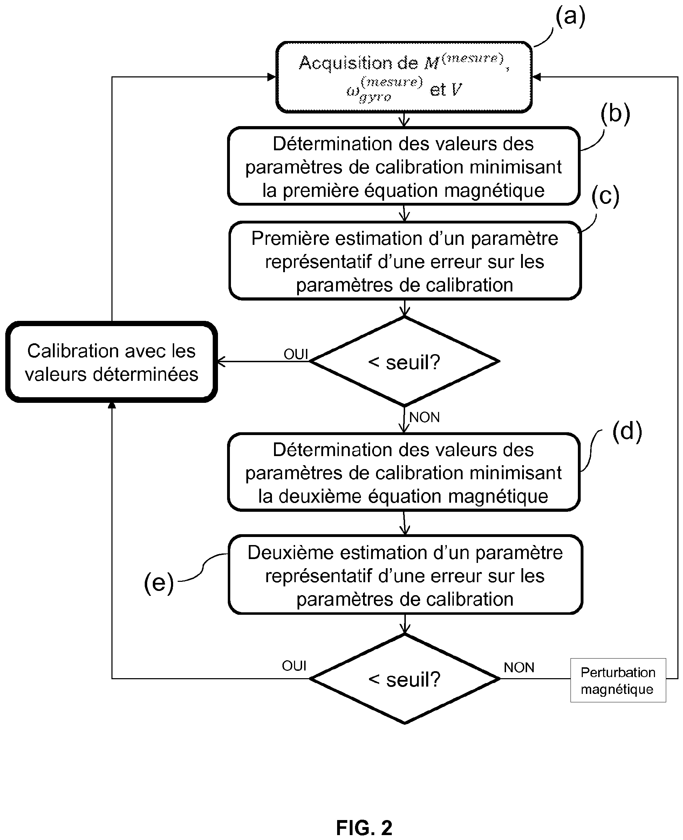

En référence à la **figure 2**, le présent procédé de calibration propose astucieusement une calibration à plusieurs niveaux d'hypothèses.

Plus précisément, dans l'étape (b) on tente initialement de calibrer le gyromètre en faisant la double hypothèse d'uniformité et de stationnarité du champ, puis dans une éventuelle étape (c) d'estimation d'un paramètre représentatif d'une erreur sur les paramètres de calibration on vérifie l'absence de perturbations, i.e. la pertinence des hypothèses.

Selon l'invention, si cette vérification échoue (ledit paramètre représentatif d'une erreur est supérieur à un seuil prédéterminé), on retente la calibration dans une étape (d) en ne faisant plus que l'hypothèse de stationnarité (et plus celle d'uniformité). On peut alors dans une étape (e) revérifier la pertinence de cette hypothèse. Alternativement, si la vérification de l'étape (c) échoue (ledit paramètre représentatif d'une erreur est supérieur à un seuil prédéterminé), on peut arrêter le procédé et garder la calibration actuelle.

On comprend que la présence de l'étape (d) permet de réaliser quand même la calibration dans les éventuels cas où le champ magnétique n'est pas uniforme, à condition d'avoir les moyens d'acquisition supplémentaire 10 évoqués précédemment. Néanmoins, selon un aspect n'appartenant pas à la présente invention, on peut se contenter de n'avoir que le gyromètre 11 et les moyens de mesure magnétique 20, et de ne mettre en œuvre que les étapes (a), (b) et éventuellement (c).

L'étape (d) comprend ainsi l'acquisition par les moyens d'acquisition supplémentaires 10 d'une vitesse linéaire mesurée de l'objet 1, notée $V$ (en pratique cette acquisition peut être mise en œuvre concomitamment avec les autres acquisitions de l'étape (a), en particulier à chaque pas de temps), puis la re-détermination par les moyens de traitement de données 21 de valeurs de l'au moins un paramètre de calibration du gyromètre 11 minimisant une deuxième expression définie par la vitesse angulaire estimée de l'objet 1 et au moins une deuxième équation magnétique sur la vitesse linéaire et les composantes du champ magnétique et/ou d'une dérivée i-ième du champ magnétique, l'au moins une deuxième équation magnétique supposant seulement un caractère stationnaire du champ magnétique au niveau des moyens de mesure magnétique 20.

On comprendra ici « acquisition » au sens large, i.e. directe ou indirecte. En pratique les moyens 10 vont le plus souvent mesurer une première grandeur qui n'est pas la vitesse linéaire (des accélérations, la fréquence de rotation d'une roue, etc.), et la vitesse linéaire dite mesurée est en fait estimée à partir de ces grandeurs, éventuellement combinées. L'homme du métier saura obtenir de nombreuses façons une vitesse linéaire de l'objet 1, par exemple par gradiométrie magnétique.

L'au moins une deuxième équation supposant seulement un caractère stationnaire du champ magnétique au niveau des moyens de mesure magnétique 20 utilisée à l'étape (d) est ainsi préférentiellement de la forme $\nabla_{\mathrm{n}}\dot{M} = f_n(\omega) \times \nabla_{\mathrm{n}}M + g_n(\nabla_{\mathrm{n+1}}M).V,$ avec $\omega$ la vitesse angulaire théorique, et comme expliqué $\dot{M} = -\omega \times M + VB \cdot V$ dans le mode de réalisation préféré dans lequel on mesure directement une composante du champ magnétique.

On comprend donc que dans une hypothèse de stationnarité du champ magnétique au niveau des moyens de mesure magnétique 20, la quantité $\nabla_{\mathrm{n}}\dot{M}^{(estimation)} - f_n\left(\omega_{gyro}^{(estimation)}\right) \times \nabla_{\mathrm{n}}M^{(estimation)} - g_n\left(\nabla_{\mathrm{n+1}}M^{(estimation)}\right).V$ (et en particulier sa version à l'ordre 0 $\dot{M}^{(estimation)} + \omega_{gyro}^{(estimation)} \times M^{(estimation)} - \nabla M^{(estimation)}.V$) est égale à zéro aux erreurs de calibration près.

Similairement l'au moins une première équation magnétique supposant un caractère uniforme et stationnaire du champ magnétique au niveau des moyens de mesure magnétique 20 utilisée à l'étape (b) est une version simplifiée de l'au moins une deuxième équation, et est préférentiellement de la forme $\nabla_{\mathrm{n}}\dot{M} = f_n(\omega) \times \nabla_{\mathrm{n}}M$, avec comme expliqué $\dot{M} = -\omega$

$\times\,M$ dans le mode de réalisation préféré dans lequel on mesure directement des composantes du champ magnétique. On comprend donc que dans une double hypothèse d'uniformité et de stationnarité du champ magnétique au niveau des moyens de mesure magnétique 20, la quantité

$$\nabla_n M^{(estimation)} - f_n\left(\omega_{gyro}^{(estimation)}\right) \times \nabla_n M^{(estimation)}$$

(et en particulier sa version à l'ordre 0

$$\dot M^{(estimation)} + \omega_{gyro}^{(estimation)} \times M^{(estimation)}$$

) est égale à zéro aux erreurs de calibration près.

On voit que la première calibration est aisée à mettre en œuvre car elle ne nécessite pas la connaissance de la vitesse linéaire $V$.

Avantageusement, la première expression (minimisée dans l'étape (b)) est fonction de

$$\dot M^{(estimation)} + \omega_{gyro}^{(estimation)} \times M^{(estimation)}$$

, et préférentiellement de

$$\left| \dot M^{(estimation)} + \omega_{gyro}^{(estimation)} \times M^{(estimation)} \right|$$

ou de

$$(\dot M^{(estimation)} + \omega_{gyro}^{(estimation)} \times M^{(estimation)})^2$$

; et la deuxième expression (minimisée à l'étape (d)) est fonction de

$$\dot M^{(estimation)} + \omega_{gyro}^{(estimation)} \times -\nabla M^{(estimation)}.V$$

, et préférentiellement de

$$\left| \dot M^{(estimation)} + \omega_{gyro}^{(estimation)} \times -\nabla M^{(estimation)}.V \right|$$

ou

$$(\dot M^{(estimation)} + \omega_{gyro}^{(estimation)} \times -\nabla M^{(estimation)}.V)^2$$

. Sous des conditions génériques, la minimisation de ces expressions donnera les paramètres sans ambiguïté pour une trajectoire générique. On comprendra cependant qu'alternativement l'homme du métier pourra utiliser comme première/deuxième expression toute autre fonctionnelle sensible à des écarts par rapport à la relation définie par la première/deuxième équation (norme $L^2$, $L^\infty$, etc.).

Pour mettre en œuvre cette minimisation, les moyens de traitement de données 21 peuvent travailler au cours du temps sur un intervalle d'une longueur donnée. A ce titre, de façon connue un filtre récursif (méthodes RLS, recursive least squares, etc.) ou une optimisation (méthode aux moindres carrés, etc.) peut être utilisé.

Par exemple, dans l'hypothèse où l'on détermine simultanément les paramètres de calibration des magnétomètres 20, i.e. les paramètres $A$ et $b_{magneto}$, on peut mettre en œuvre un principe dit de calibration différentielle dans lequel on minimise

$$\int \left| \dot M^{(estimation)} + \omega_{gyro}^{(estimation)} \times M^{(estimation)} \right|^2 dt$$

ou

$$\int \left| \dot M^{(estimation)} + \omega_{gyro}^{(estimation)} \times M^{(estimation)} - \nabla M^{(estimation)}.V \right|^2 dt$$

, avec

$$\omega_{gyro}^{(estimation)} = D \cdot (\omega_{gyro}^{(mesure)} + b)$$

et $M^{(estimation)} = A^{-1} \cdot (M^{(mesure)} - b_{magnéto})$ aux moindre carrés.

*Caractérisation d'erreur*

Comme expliqué, le procédé comprend avantageusement une étape (c) d'estimation d'un paramètre représentatif d'une erreur sur les paramètres de calibration, et encore plus avantageusement (si les étapes (c) et (d) ont eu lieu) une étape (e) de nouvelle estimation dudit paramètre représentatif d'une erreur sur les paramètres de calibration.

L'idée est d'estimer la qualité de l'information fournie par les moyens de mesure magnétique 20 pour valider ou non les niveaux d'hypothèses sur le champ magnétique ambiant. Plus précisément, et comme l'on voit sur la figure 2 :

- si la première estimation (étape (c)) du paramètre représentatif d'une erreur est inférieure audit seuil prédéterminé, on valide la double hypothèse d'uniformité et stationnarité du champ magnétique ambiant et le résultat de la calibration de l'étape (b) est accepté. L'étape (c) comprend alors la calibration effective du gyromètre 11 et/ou des moyens de mesure magnétique 20 avec les valeurs déterminées à l'étape (b) des paramètres de calibration, et il n'y a pas lieu de mettre en œuvre les étapes (d) et (e) ;
- si la première estimation (étape (c)) du paramètre représentatif d'une erreur est supérieure audit seuil prédéterminée, on rejette la double hypothèse d'uniformité et stationnarité du champ magnétique ambiant et le résultat de la calibration de l'étape (b) n'est pas accepté, on peut soit s'arrêter, soit mettre en œuvre la recalibration de l'étape (d) :

◦ si la deuxième estimation (étape (e)) du paramètre représentatif d'une erreur est cette fois inférieure audit seuil prédéterminée, on valide l'hypothèse de seule stationnarité du champ magnétique ambiant et le résultat de la calibration de l'étape (d) est accepté. L'étape (e) comprend alors la calibration effective du gyromètre 11 et/ou des moyens de mesure magnétique 20 avec les valeurs déterminées à l'étape (d) des paramètres de calibration ;
◦ si la deuxième estimation (étape (e)) du paramètre représentatif d'une erreur est toujours supérieure audit seuil prédéterminée, on rejette même l'hypothèse de stationnarité du champ magnétique ambiant (on est en présence de perturbations) et le résultat de la calibration de l'étape (d) n'est pas accepté. On garde alors les paramètres de l'ancienne calibration comme calibration. On peut alors soit tenter d'utiliser l'équation magnétique complète (avec le terme $\frac{\partial M}{\partial t}$), soit écarter temporairement les mesures magnétiques.

A noter que des valeurs déterminées des paramètres de calibrations lors d'une occurrence de l'étape (b) et/ou (d), mais non utilisées pour la calibration effective, peuvent être stockées sur les moyens de stockage de données 12, et utilisées lors d'une future occurrence de l'étape (c) et/ou (e). Par exemple, on peut prévoir que tant que le paramètre représentatif d'une erreur est au-dessus du seuil, on stocke les paramètres de calibration déterminés, et lorsqu'on passe en dessous du seuil, la calibration effective tient également compte des valeurs stockées. Par ailleurs, le résultat des étapes (c) et (e) peut dépendre de l'âge des paramètres de l'ancienne calibration (par exemple via la valeur du seuil).

A noter qu'un intervalle d'erreur accumulée après une durée t depuis la dernière bonne calibration peut être estimé en fonction de cette durée t et de l'erreur estimée dans cette calibration, par exemple en ajoutant à cette erreur un incrément qui est proportionnel à la durée t. L'intervalle d'erreur prédit peut servir pour caractériser le résultat d'une future calibration, et notamment pour définir la valeur dudit seuil prédéterminé : par exemple plus l'intervalle d'erreur est grand, plus il est urgent de recalibrer le gyromètre, et ainsi plus l'on sera « tolérant » avec la valeur du paramètre représentatif d'une erreur (i.e. le seuil prédéterminé sera plus haut). Par ailleurs, dans la mesure où l'intervalle d'erreur augmente proportionnellement plus vite lorsque l'erreur estimée est élevée, cela permet de conserver longtemps les « bonnes » calibrations avec une erreur estimée très faible, tout en forçant plus rapidement à recalibrer les calibrations « moins bonnes ».

De façon générale, ledit paramètre représentatif d'une erreur sur les paramètres de calibration est fonction de la valeur de la première/deuxième expression (selon si c'est la première ou deuxième occurrence d'estimation du paramètre), calculée pour les valeurs déterminées des paramètres de calibration.

Un premier mode de réalisation de l'étape (c)/(e) est dit intrinsèque puisqu'il n'utilise que des grandeurs disponibles dans l'étape (b)/(d). De façon préférée, on utilise les résidus d'estimation de l'étape (b)/(d), i.e. ledit paramètre représentatif d'une erreur est en particulier la norme (p.ex. $L^2$ ou $L^\infty$) de la valeur de la première/deuxième expression sur un intervalle de temps donné, typiquement $\int \left| \dot{M}^{(estimation)} + \omega^{(estimation)}_{gyro} \times M^{(estimation)} \right|^2 dt$ ou

$\int \left| \dot{M}^{(estimation)} + \omega^{(estimation)}_{gyro} \times \right.$ $M^{(estimation)} - \nabla M^{(estimation)}. V|^2 dt$. Dans un tel cas, l'étape (c)/(e) peut être mise en œuvre de façon concomitante avec l'étape (b)/(d). Dans le cas d'un filtre récursif, on peut utiliser la norme (p.ex. $L^2$ ou $L^\infty$) de l'innovation du filtre sur une période de temps donné.

Alternativement, on peut quantifier la déviation par rapport à une distribution normale, i.e. regarder si la statistique de $\dot{M}^{(estimation)} + \omega^{(estimation)}_{gyro}. M^{(estimation)}$ (ou $\dot{M}^{(estimation)} + \omega^{(estimation)}_{gyro}. M^{(estimation)} - \nabla M^{(estimation)}. V$) est similaire à une statistique de bruit gaussien ou non, par exemple en calculant les moments d'ordre supérieurs à 2.

Dans un deuxième mode de réalisation de l'étape (c)/(e), dit extrinsèque, on utilise des grandeurs d'un autre type, de sorte à calculer sur la base d'une ou l'autre de ces grandeurs une vitesse angulaire dite de référence, de sorte à la comparer avec la vitesse angulaire estimée. Et l'homme du métier saura calculer une telle vitesse angulaire de référence à partir de divers type de grandeurs, et en particulier on pourra utiliser par exemple :

- un angle volant (si l'objet 1 est un véhicule),
- des données GNSS, p.ex. GPS, (si/quand disponibles),
- des données odométriques.

Dans le dernier cas, si les moyens d'acquisition supplémentaire 10 d'une vitesse linéaire consistent en au moins deux odomètres (toujours si l'objet 1 est un véhicule), ladite vitesse angulaire théorique peut en effet être obtenue à partir des vitesses mesurées de roues. En particulier, dans le cas où les roues arrières sont chacune munie d'un odomètre, en supposant la géométrie différentielle d'Ackermann, une deuxième vitesse angulaire estimée $\omega_{odo}^{(estimation)}$ de l'objet 1 est liée aux vitesses mesurées $v_L$, $v_R$ respectivement pour la roue arrière gauche et la roue arrière droite par une formule du type $\omega_{odo}^{(estimation)} = \frac{v_R - v_L}{d}$, avec d la distance entre les roues, et ledit paramètre représentatif d'une erreur est alors en particulier la norme (p.ex. $L^2$ ou $L^\infty$) de $\left|\omega_{\uparrow,gyro}^{(estimation)} - \omega_{odo}^{(estimation)}\right|^2$ sur l'intervalle de temps donné, où $\omega_{\uparrow,gyro}^{(estimation)}$ est la vitesse angulaire pour la rotation seule autour de l'axe vertical de l'objet 1.

Selon un troisième mode de réalisation, en ce qui concerne la première occurrence (étape (c)) de l'estimation du paramètre d'erreur, on peut tout simplement estimer tout ou partie d'un gradient spatial de ladite composante du champ magnétique et/ou d'une dérivée i-ième du champ magnétique, i.e. $\nabla M$ ou $\nabla_{i+1} M$ selon l'ordre de la deuxième équation utilisée.

En effet, cette estimation doit être proche de zéro pour que le caractère uniforme soit retenu. On comprend que l'estimation d'un sous-ensemble des composantes du gradient peut en pratique suffire pour cette caractérisation, car chaque composante non-nulle est déjà une manifestation d'une inhomogénéité.

Alternativement ou en complément, on peut recourir à de l'apprentissage pour améliorer l'estimation de ce paramètre d'erreur et/ou développer une approche d'identification de conditions favorables (i.e. stationnaires et uniformes) de manière plus robuste et avec une disponibilité augmentée.

En particulier, on peut mettre en œuvre des mécanismes d'apprentissage tels que des réseaux de neurones, machines à vecteurs de support, méthodes des plus proches voisins, forêts d'arbres décisionnels, etc. Ainsi, à chaque occurrence des étapes (b) à (e), on peut venir enrichir une base d'apprentissage dans laquelle chaque ensemble de données de mesures est « taggué » avec la valeur correspondante du paramètre représentatif d'une erreur, de sorte à progressivement (au fur et à mesure des occurrences successives des étapes (b) à (e)) et automatiquement apprendre à distinguer les calibrations acceptables de celles non acceptables. Ainsi, le calibrage s'améliore de lui-même en permanence.

*Estimation du mouvement*

Comme expliqué, le procédé comprend avantageusement une étape (f) d'estimation par les moyens de traitement de données 21 du mouvement dudit objet 1 en fonction de la vitesse angulaire mesurée de l'objet 1 et/ou des au moins deux composantes du champ magnétique et/ou d'une dérivée i-ième du champ magnétique, et/ou de l'éventuelle vitesse linéaire mesuré de l'objet 1 (par les moyens 10), et des valeurs des paramètres de calibration, i.e. après recalibration. Cette étape (f), qui n'est pas représentée sur la figure 2 qui se concentre sur la calibration, peut être mise en œuvre en continu parallèlement.

Par estimation du mouvement, on entend en particulier au moins l'estimation d'une orientation de l'objet 1 (dans le plan horizontal, i.e. un cap) et avantageusement l'estimation d'une norme de vitesse. L'orientation s'obtient typiquement par intégration de la vitesse angulaire à partir d'une orientation initiale connue.

De façon préférée, l'estimation par les moyens de traitement de données 21 du cap dudit objet 1 est uniquement faite en fonction de la vitesse angulaire mesurée de l'objet 1 et des valeurs des paramètres de calibration, i.e. en utilisant les seules données gyrométriques. En résumé, on utilise les données magnétiques pour calibrer le gyromètre 11, et ensuite on n'utilise pour l'estimation du cap que les données gyrométriques (puisque celles-ci sont toujours disponibles). Le cas échéant, la vitesse linéaire mesuré (obtenue via les moyens 10) n'est utilisée dans l'étape (f) que pour déterminer une vitesse globale de l'objet 1.

A noter que dans un cas de véhicule autonome, l'étape (f) peut comprendre la génération d'une commande dudit véhicule 1 en fonction du mouvement estimé, de sorte à amener le véhicule 1 par exemple jusqu'à une destination souhaitée, ou à stopper le véhicule 1 en le gardant dans une trajectoire dénuée d'obstacles.

*Equipements et objet*

Selon un deuxième aspect, l'invention concerne en particulier un ensemble des équipements 11, 20, 21 et éventuellement 10 pour la mise en œuvre de l'un ou l'autre des modes de réalisation du procédé.

Cet ensemble peut être installé en kit dans un objet 1 « classique » de sorte le transformer. Alternativement, en particulier dans le cas où l'objet 1 est un véhicule, ce peut être un véhicule autonome déjà muni de moyens de traitement de données 21 pour la navigation du véhicule, ainsi que de capteurs tels que le gyromètre 11 et/ou des odomètres servant de moyens d'acquisition supplémentaire 10.

En particulier est proposé un objet 1, en particulier de type véhicule à roues, comprenant :

- un gyromètre 11 configuré pour acquérir une vitesse angulaire mesurée de l'objet 1 ;
- des moyens de mesure magnétique 20 configurés pour acquérir au moins deux composantes du champ magnétique et/ou d'une dérivée i-ième du champ magnétique ;
- le cas échéant, des moyens d'acquisition supplémentaire 10 configurés pour acquérir une vitesse linéaire mesurée de l'objet 1 (avantageusement des odomètres équipant au moins deux des roues du véhicule et configurés pour acquérir des vitesses mesurées desdites deux roues) ;
- des moyens de traitement de données 21 configurés pour

  ○ déterminer des valeurs d'au moins un paramètre de calibration du gyromètre 11 minimisant une première expression définie par une vitesse angulaire estimée de l'objet 1 et au moins une première équation magnétique sur les composantes du champ magnétique et/ou d'une dérivée i-ième du champ magnétique,

    ■ la vitesse angulaire estimée de l'objet 1 étant fonction de la vitesse angulaire mesurée et de paramètres de calibration du gyromètre 11, et
    ■ l'au moins une première équation magnétique supposant un caractère uniforme et stationnaire du champ magnétique au niveau des moyens de mesure magnétique 20,

- les moyens de traitement de données 21 étant configurés pour:

  ○ Estimer un paramètre représentatif d'une erreur sur les paramètres de calibration ; et
  ○ Si ledit paramètre représentatif d'une erreur est supérieur à un seuil prédéterminé, re-déterminer des valeurs de l'au moins un paramètre de calibration du gyromètre 11 une deuxième expression définie par la vitesse angulaire estimée de l'objet 1 et au moins une deuxième équation magnétique sur la vitesse linéaire mesurée et les composantes du champ magnétique et/ou d'une dérivée i-ième du champ magnétique, l'au moins une deuxième équation magnétique supposant seulement un caractère stationnaire du champ magnétique au niveau des moyens de mesure magnétique 20.

Comme expliqué précédemment, l'objet 1 peut en outre comprendre une mémoire 22 et une interface 23, ainsi que d'autre capteurs comme un capteur angulaire du volant ou un récepteur GNSS.

Par ailleurs, les moyens de traitement de données 21 peuvent être en outre configurés pour estimer un mouvement dudit objet 1 en fonction de la vitesse angulaire mesurée de l'objet 1, des composantes du champ magnétique et/ou d'une dérivée i-ième du champ magnétique, et/ou de l'éventuelle vitesse linéaire mesurée de l'objet 1 (le cas échéant selon le résultat d'une comparaison dudit paramètre représentatif d'une erreur avec un seuil), et des valeurs des paramètres de calibration.

*Produit programme d'ordinateur*

Selon un troisième et un quatrième aspect, l'invention concerne un produit programme d'ordinateur comprenant des instructions de code pour l'exécution (sur les moyens de traitement 21) d'un procédé de calibration d'un gyromètre 11 selon le premier aspect de l'invention, ainsi que des moyens de stockage lisibles par un équipement informatique (par exemple des moyens de stockage de données 22) sur lequel on trouve ce produit programme d'ordinateur.

**Revendications**

1. Procédé **de calibration d'un** gyromètre (11) équipant un objet (1) évoluant dans un champ magnétique ambiant, le procédé comprenant des étapes de :

   (a) acquisition

     - par le gyromètre (11), **d'**une vitesse angulaire mesurée **de l'objet** (1), et
     - par des moyens de mesure magnétique (20) solidaires dudit **objet (1), d'au moins** deux composantes du champ magnétique **et/ou d'une dérivée** i-ième du champ magnétique, au niveau des moyens de mesure magnétique (20) ;

(b) détermination par des moyens de traitement de données (21) de valeurs d'**au moins un** paramètre de calibration du gyromètre (11) minimisant une première expression définie par une vitesse angulaire estimée de **l'objet** (1) et au moins une première équation magnétique sur les composantes **du champ magnétique et/ou d'une dérivée i-**ième du champ magnétique,

- la vitesse angulaire estimée **de l'objet** (1) étant fonction de la vitesse angulaire mesurée et de paramètres de calibration du gyromètre (11), et
- l'au moins une première équation magnétique supposant un caractère uniforme et stationnaire du champ magnétique au niveau des moyens de mesure magnétique (20) ;

(c) **estimation d'un paramètre représentatif d'une erreur sur les** paramètres de calibration ;

**le procédé étant caractérisé en ce qu'il comprend en outre l'étape** de :
(d) **si ledit paramètre représentatif d'une erreur est supérieur à un seuil** prédéterminé, **acquisition par des moyens d'acquisition supplémentaires (10) d'une vitesse linéaire mesurée de l'objet (1)** et re-détermination par les moyens de traitement de données (21) de **valeurs de l'au moins un paramètre de calibration du gyromètre (11)** minimisant une deuxième expression définie par la vitesse angulaire **estimée de l'objet (1) et au moins une deuxième équation** magnétique sur les composantes **du champ magnétique et/ou d'une** dérivée i-ième du champ magnétique et sur la vitesse linéaire mesurée, **l'au** moins une **deuxième équation magnétique supposant** seulement un caractère stationnaire du champ magnétique au niveau des moyens de mesure magnétique (20).

2. Procédé selon la revendication 1, dans laquelle la vitesse angulaire estimée $\omega_{gyro}^{(estimation)}$ **de l'objet** (1) est liée à la vitesse angulaire mesurée $\omega_{gyro}^{(mesure)}$ par un modèle $\omega_{gyro}^{(estimation)} = D \cdot (\omega_{gyro}^{(mesure)} + b_{gyro})$, où $D$ et $b_{gyro}$ sont les paramètres de calibration du gyromètre (11).

3. Procédé selon la revendication 1 ou 2, dans laquelle, lors de l'étape (c), **ledit paramètre représentatif d'une erreur sur les** paramètres de calibration est fonction de la valeur de ladite première expression, calculée pour les valeurs déterminées des paramètres de calibration.

4. Procédé selon **l'une des revendications** 1 à 3, comprenant une étape (e) de nouvelle estimation dudit paramètre **représentatif d'une erreur sur** les paramètres de calibration.

5. Procédé selon la revendication 4, dans laquelle, lors de l'étape (e), **ledit paramètre représentatif d'une erreur sur les paramètres de** calibration est fonction de la valeur de ladite deuxième expression, calculée pour les valeurs déterminées des paramètres de calibration.

6. Procédé selon **l'une des revendications** 1 à 5, dans laquelle **l'étape (c) comprend la détermination d'un intervalle d'erreur accumulée en fonction de la valeur dudit paramètre représentatif d'une erreur sur les paramètres de calibration et d'une durée depuis la dernière** calibration du gyromètre (11), ledit seuil prédéterminé dépendant dudit **intervalle d'erreur accumulée.**

7. Procédé selon **l'une des revendications** 1 à 6, dans lequel les composantes **du champ magnétique et/ou d'une dérivée** i-ième du champ magnétique acquises **à l'étape (a)** sont des composantes mesurées, et celles utilisées par la ou les premières équations magnétiques, et la ou les deuxièmes équations magnétiques, sont des composantes estimées en fonction des composantes mesurées et de paramètres de calibration des moyens de mesure magnétique (20), **l'étape** (b) et **l'étape (d)** comprenant également la détermination de valeurs d'**au** moins un paramètre de calibration des moyens de mesure magnétique (20).

8. Procédé selon la revendication 7, dans laquelle les moyens de mesure magnétique (20) sont des magnétomètres triaxes, les composantes estimées $M^{(estimation)}$ du champ magnétique étant liées aux composantes mesurées $M^{(mesure)}$ par un modèle $M^{(mesure)} = A \cdot M^{(estimation)} + b_{magneto}$, où $A$ et $b_{magneto}$ sont les paramètres de calibration des moyens de mesure magnétique (20).

9. Procédé selon **l'une des** revendications 1 à 8, dans lequel la ou les premières équations magnétiques sont de la forme

$$\dot{\nabla}_{n}M = f_n(\omega) \times \nabla_n M,$$ et la ou les deuxièmes équations magnétiques sont de la forme

$$\dot{\nabla}_{n}M = f_n(\omega) \times \nabla_n M + g_n(\nabla_{n+1}M).V,$$ où $\nabla_n M$ est une dérivée n-ième du champ magnétique, $\omega$ la vitesse angulaire, $V$ la vitesse linéaire, et $f_n$ et $g_n$ des fonctions prédéterminées.

10. Procédé selon la revendication 9, dans lequel la première expression est fonction de

$$\dot{\nabla}_{n}M^{(estimation)} - f_n\left(\omega_{gyro}^{(estimation)}\right) \times \nabla_n M^{(estimation)}$$ et la deuxième expression est fonction de

$$\dot{\nabla}_{n}M^{(estimation)} - f_n\left(\omega_{gyro}^{(estimation)}\right) \times \nabla_n M^{(estimation)} - g_n\left(\nabla_{n+1}M^{(estimation)}\right).V.$$

11. Procédé selon les revendications 5 et 10 en combinaison, **dans laquelle** ledit **paramètre** représentatif **d'une erreur** sur les paramètres de calibration est soit la moyenne de

$$\left|\dot{\nabla}_{n}M^{(estimation)} - f_n\left(\omega_{gyro}^{(estimation)}\right) \times \nabla_n M^{(estimation)}\right|^2,$$ ou

$$\left|\dot{\nabla}_{n}M^{(estimation)} - f_n\left(\omega_{gyro}^{(estimation)}\right) \times \nabla_n M^{(estimation)} - g_n(\nabla_{n+1}M^{(estimation)}).V\right|^2$$ sur un intervalle de temps **donné,** soit tout ou **partie d'un** gradient **spatial desdites** composantes du **champ magnétique et/ou d'une dérivée** i-ième du champ magnétique.

12. Procédé selon l'une **des** revendications 1 à 11, comprenant une étape (f) d'estimation par les moyens de traitement de données (21) du mouvement dudit objet (1) en fonction de la vitesse angulaire mesurée de **l'objet** (1), des composantes du champ magnétique **et/ou d'une dérivée** i-ième du champ magnétique, et/ou de **l'éventuelle** vitesse linéaire **mesurée de l'objet** (1), et des valeurs des paramètres de calibration, dans lequel une orientation **de l'objet (1) est estimée à l'étape (f)** uniquement en fonction de la vitesse angulaire mesurée **de l'objet** (1) et des valeurs des paramètres de calibration.

13. Objet (1) évoluant dans un champ magnétique ambiant, comprenant un gyromètre (11) configuré pour acquérir une vitesse angulaire mesurée de **l'objet** (1), des moyens de mesure magnétique (20) configurés pour acquérir au moins deux composantes du champ **magnétique et/ou d'une dérivée** i-ième du champ magnétique, des moyens **d'acquisition supplémentaires** (10) configurés pour acquérir une vitesse linéaire **mesurée de l'objet** (1), l'objet (1) comprenant en outre des moyens de traitement de données (21) configurés pour :

- déterminer des **valeurs d'au moins un paramètre de calibration du** gyromètre (11) minimisant une première expression définie par une **vitesse angulaire estimée de l'objet (1) et au moins une première** équation magnétique sur les composantes du champ magnétique **et/ou d'une dérivée** i-ième du champ magnétique,

∘ la **vitesse angulaire estimée de l'objet** (1) étant fonction de la vitesse angulaire mesurée et de paramètres de calibration du gyromètre (11), et
∘ l'au moins une première équation magnétique supposant un caractère uniforme et stationnaire du champ magnétique au niveau des moyens de mesure magnétique (20) ;

- estimer un **paramètre représentatif d'une erreur sur les paramètres** de calibration ;

**l'objet étant caractérisé en ce que** les moyens de traitement de données (21) sont en outre configurés pour :

- si **ledit paramètre représentatif d'une erreur est supérieur à un seuil** prédéterminé, re-déterminer des **valeurs de l'au moins un paramètre** de calibration du gyromètre (11) minimisant une deuxième **expression définie par la vitesse angulaire estimée de l'objet (1) et au** moins une deuxième équation magnétique sur la vitesse linéaire mesurée et sur les composantes **du champ magnétique et/ou d'une** dérivée i-ième du champ magnétique, **l'au moins une deuxième** équation magnétique supposant seulement un caractère stationnaire du champ magnétique au niveau des moyens de mesure magnétique (20).

**14.** **Produit programme d'ordinateur comprenant des instructions de code pour l'exécution d'un procédé de calibration d'un** gyromètre (11) **selon l'une des revendications 1 à** 12, lorsque ledit programme est exécuté sur un ordinateur.

**Patentansprüche**

**1.** Verfahren zum Kalibrieren eines Gyrometers (11), der ein Objekt (1) ausstattet, das sich in einem Umgebungsmagnetfeld bewegt, wobei das Verfahren folgende Schritte umfasst:

(a) Erfassen

- durch das Gyrometer (11), einer gemessenen Winkelgeschwindigkeit des Objekts (1), und
- durch Magnetmessmittel (20), die mit dem Objekt (1) fest verbunden sind, von mindestens zwei Komponenten des Magnetfeldes und/oder einer i-ten Ableitung des Magnetfeldes an den Magnetmessmitteln (20);

(b) Bestimmen, durch Datenverarbeitungsmittel (21), von Werten mindestens eines Kalibrierungsparameters des Gyrometers (11), der einen ersten Ausdruck minimiert, der durch eine geschätzte Winkelgeschwindigkeit des Objekts (1) und mindestens eine erste magnetische Gleichung für die Komponenten des Magnetfeldes und/oder eine i-te Ableitung des Magnetfeldes definiert ist, wobei

- die geschätzte Winkelgeschwindigkeit des Objekts (1) eine Funktion der gemessenen Winkelgeschwindigkeit und der Kalibrierungsparameter des Gyrometers (11) ist, und
- die mindestens eine erste magnetische Gleichung eine einheitliche und stationäre Beschaffenheit des Magnetfeldes an den Magnetmessmitteln (20) voraussetzt;

(c) Schätzen eines einen Fehler bei den Kalibrierungsparametern darstellenden Parameters;

wobei das Verfahren **dadurch gekennzeichnet ist, dass** es ferner folgenden Schritt umfasst:
(d) falls der einen Fehler darstellende Parameter größer als eine vorbestimmte Schwelle ist, Erfassen durch zusätzliche Erfassungsmittel (10) einer gemessenen linearen Geschwindigkeit des Objekts (1) und erneutes Bestimmen durch die Datenverarbeitungsmittel (21) von Werten des mindestens einen Kalibrierungsparameters des Gyrometers (11), der einen zweiten Ausdruck minimiert, der durch die geschätzte Winkelgeschwindigkeit des Objekts (1) und mindestens eine zweite magnetische Gleichung für die Komponenten des Magnetfeldes und/oder einer i-ten Ableitung des Magnetfeldes und für die gemessene lineare Geschwindigkeit definiert ist, wobei die mindestens eine zweite magnetische Gleichung nur eine stationäre Beschaffenheit des Magnetfeldes an den Magnetmessmitteln (20) voraussetzt.

**2.** Verfahren nach Anspruch 1, wobei die geschätzte Winkelgeschwindigkeit $\omega_{gyro}^{(estimation)}$ des Objekts (1) mit der gemessenen Winkelgeschwindigkeit $\omega_{gyro}^{(mesure)}$ über ein Modell $\omega_{gyro}^{(estimation)} = D \cdot (\omega_{gyro}^{(mesure)} + b_{gyro})$ zusammenhängt, wobei $D$ und $b_{gyro}$ die Kalibrierungsparameter des Gyrometers (11) sind.

**3.** Verfahren nach Anspruch 1 oder 2, wobei in Schritt (c) der einen Fehler bei den Kalibrierungsparametern darstellende Parameter eine Funktion des Wertes des ersten Ausdrucks ist, der für die bestimmten Werte der Kalibrierungsparameter berechnet wird.

**4.** Verfahren nach einem der Ansprüche 1 bis 3, umfassend einen Schritt (e) zum erneuten Schätzen des einen Fehler bei den Kalibrierungsparametern darstellenden Parameters.

**5.** Verfahren nach Anspruch 4, wobei in Schritt (e) der einen Fehler bei den Kalibrierungsparametern darstellende Parameter eine Funktion des Wertes des zweiten Ausdrucks ist, der für die bestimmten Werte der Kalibrierungsparameter berechnet wird.

**6.** Verfahren nach einem der Ansprüche 1 bis 5, wobei Schritt (c) die Bestimmung eines kumulierten Fehlerintervalls in Abhängigkeit von dem Wert des einen Fehler bei den Kalibrierungsparametern darstellenden Parameters und einer Dauer seit der letzten Kalibrierung des Gyrometers (11) umfasst, wobei die vorbestimmte Schwelle von dem kumulierten Fehlerintervall abhängig ist.

**7.** Verfahren nach einem der Ansprüche 1 bis 6, wobei die Komponenten des Magnetfeldes und/oder einer i-ten Ableitung des Magnetfeldes, die in Schritt (a) erfasst wurden, gemessene Komponenten sind, und diejenigen, die von der oder den ersten magnetischen Gleichungen und von der oder den zweiten magnetischen Gleichungen verwendet werden, geschätzte Komponenten sind, die in Abhängigkeit von den gemessenen Komponenten und von Kalibrierungsparametern der Magnetmessmittel (20) geschätzt werden, wobei Schritt (b) und Schritt (d) auch die Bestimmung von Werten mindestens eines Kalibrierungsparameters der Magnetmessmittel (20) umfassen.

**8.** Verfahren nach Anspruch 7, wobei die Magnetmessmittel (20) dreiachsige Magnetometer sind, wobei die geschätzten Komponenten $M^{(estimation)}$ des Magnetfeldes mit den gemessenen Komponenten $M^{(mesure)}$ über ein Modell $M^{(mesure)} = A \cdot M^{(estimation)} + b_{magneto}$ zusammenhängen, wobei $A$ und $b_{magneto}$ die Kalibrierungsparameter der Magnetmessmittel (20) sind.

**9.** Verfahren nach einem der Ansprüche 1 bis 8, wobei die erste(n) magnetische(n) Gleichung (en) in der Form von

$$\dot{\nabla_n M} = f_n(\omega) \times \nabla_n M$$

vorliegen und die zweite(n) magnetische (n) Gleichung (en) in der Form von

$$\dot{\nabla_n M} = f_n(\omega) \times \nabla_n M + g_n(\nabla_{n+1} M).V$$ vorliegen, wobei $\nabla_n M$ eine n-te Ableitung des Magnetfeldes ist, $\omega$ die Winkelgeschwindigkeit ist, $V$ die lineare Geschwindigkeit ist und $f_n$ und $g_n$ vorbestimmte Funktionen sind.

**10.** Verfahren nach Anspruch 9, wobei der erste Ausdruck eine Funktion von

$$\dot{\nabla_n M^{(estimation)}} - f_n\left(\omega_{gyro}^{(estimation)}\right) \times \nabla_n M^{(estimation)}$$ ist, und der zweite Ausdruck eine Funktion von

$$\dot{\nabla_n M^{(estimation)}} - f_n\left(\omega_{gyro}^{(estimation)}\right) \times \nabla_n M^{(estimation)} - g_n(\nabla_{n+1} M^{(estimation)}).V$$ ist

**11.** Verfahren nach Anspruch 5 und 10 kombiniert, wobei der einen Fehler bei den Kalibrierungsparametern darstellende Parameter entweder der Mittelwert von $\left| \dot{\nabla_n M^{(estimation)}} - f_n\left(\omega_{gyro}^{(estimation)}\right) \times \nabla_n M^{(estimation)} \right|^2$

oder $\left| \dot{\nabla_n M^{(estimation)}} - f_n\left(\omega_{gyro}^{(estimation)}\right) \times \nabla_n M^{(estimation)} g_n(\nabla_{n+1} M^{(estimation)}).V \right|^2$ in einem gegebenen Zeitintervall ist, oder aber ganz oder teilweise ein räumlicher Gradient der Komponenten des Magnetfeldes und/oder einer i-ten Ableitung des Magnetfeldes ist.

**12.** Verfahren nach einem der Ansprüche 1 bis 11, umfassend einen Schritt (f) zum Schätzen durch die Datenverarbeitungsmittel (21) der Bewegung des Objekts (1) in Abhängigkeit von der gemessenen Winkelgeschwindigkeit des Objekts (1), der Komponenten des Magnetfeldes und/oder einer i-ten Ableitung des Magnetfeldes und/oder der eventuellen gemessenen linearen Geschwindigkeit des Objekts (1) und den Werten der Kalibrierungsparameter, wobei eine Orientierung des Objekts (1) in Schritt (f) nur in Abhängigkeit von der gemessenen Winkelgeschwindigkeit des Objekts (1) und den Werten der Kalibrierungsparameter geschätzt wird.

**13.** Objekt (1), das sich in einem Umgebungsmagnetfeld bewegt, umfassend ein Gyrometer (11), das dazu konfiguriert ist, eine gemessene Winkelgeschwindigkeit des Objekts (1) zu erfassen, Magnetmessmittel (20), die dazu konfiguriert sind, mindestens zwei Komponenten des Magnetfeldes und/oder einer i-ten Ableitung des Magnetfeldes zu erfassen, zusätzliche Erfassungsmittel (10), die dazu konfiguriert sind, eine gemessene lineare Geschwindigkeit des Objekts (1) zu erfassen, wobei das Objekt (1) ferner Datenverarbeitungsmittel (21) umfasst, die konfiguriert sind zum:

- Bestimmen der Werte mindestens eines Kalibrierungsparameters des Gyrometers (11), der einen ersten Ausdruck minimiert, der durch eine geschätzte Winkelgeschwindigkeit des Objekts (1) und mindestens eine erste magnetische Gleichung für die Komponenten des Magnetfeldes und/oder einer i-ten Ableitung des Magnetfeldes definiert ist, wobei

∘ die geschätzte Winkelgeschwindigkeit des Objekts (1) eine Funktion der gemessenen Winkelgeschwindigkeit und von Kalibrierungsparametern des Gyrometers (11) ist, und
∘ die mindestens eine erste magnetische Gleichung eine einheitliche und stationäre Beschaffenheit des Magnetfeldes an den Magnetmessmitteln (20) voraussetzt;

- Schätzen eines Parameters, der einen Fehler bei den Kalibrierungsparametern darstellt;

wobei das Objekt **dadurch gekennzeichnet ist, dass** die Datenverarbeitungsmittel (21) ferner konfiguriert sind zum:

- falls der einen Fehler darstellende Parameter größer als eine vorbestimmte Schwelle ist, erneutes Erfassen der Werte des mindestens einen Kalibrierungsparameters des Gyrometers (11), der einen zweiten Ausdruck minimiert, der durch die geschätzte Winkelgeschwindigkeit des Objekts (1) und mindestens eine zweite magnetische Gleichung für die gemessene lineare Geschwindigkeit und für die Komponenten des Magnetfeldes und/oder einer i-ten Ableitung des Magnetfeldes gemessen wird, wobei die mindestens eine zweite magnetische Gleichung nur eine stationäre Beschaffenheit des Magnetfeldes an den Magnetmessmitteln (20) voraussetzt.

14. Computerprogrammprodukt, umfassend Codeanweisungen zum Ausführen eines Verfahrens zum Kalibrieren eines Gyrometers (11) nach einem der Ansprüche 1 bis 12, wenn das Programm auf einem Computer ausgeführt wird.

**Claims**

1. Method for calibrating a gyrometer (11) of an object (1) moving in an ambient magnetic field, the method comprising the steps of:

    (a) acquisition

        - by the gyrometer (11), of a measured angular velocity of the object (1), and
        - by magnetic measuring means (20) which are secured to said object, (1) of at least two components of the magnetic field and/or of an i-th derivative of the magnetic field, around the magnetic measurement means (20);

    (b) determining, by data processing means (21), values of at least one calibration parameter of the gyrometer (11) minimising a first expression defined by an estimated angular velocity of the object (1) and at least one first magnetic equation on the components of the magnetic field and/or of an i-th derivative of the magnetic field,

        - the estimated angular velocity of the object (1) being a function of the measured angular velocity and of calibration parameters of the gyrometer (11), and
        - the at least one first magnetic equation assuming that the magnetic field is uniform and stationary around the magnetic measurement means (20);

    (c) estimating a parameter representative of an error on the calibration parameters.

    the method being **characterised in that** it further comprises the step of:
    (d) if said parameter representative of an error is greater than a predetermined threshold, acquiring by additional acquisition means (10) a measured linear velocity of the object (1) and re-determining by the data processing means (21) values of the at least one calibration parameter of the gyrometer (11) minimising a second expression defined by the estimated angular velocity of the object (1) and at least one second magnetic equation on the components of the magnetic field and/or of an i-th derivative of the magnetic field and on the measure linear velocity, the at least one second magnetic equation assuming only that the magnetic field is stationary around the magnetic measurement means (20)

2. Method according to claim 1, wherein the estimated angular velocity $\omega_{gyro}^{(estimation)}$ of the object (1) is linked to the measured angular velocity $\omega_{gyro}^{(measurement)}$ by a model $\omega_{gyro}^{(estimation)} = D \cdot (\omega_{gyro}^{(measurement)} + b_{gyro})$, where $D$ and $b_{gyro}$ are the calibration parameters of the gyrometer (11).

3. Method according to claim 1 or 2, wherein, during step (c), said parameter representative of an error on the calibration parameters is a function of the value of said first expression calculated for the determined values of the calibration parameters.

4. Method according to one of claims 1 to 3, comprising a step (e) of a new estimating of said parameter representative of an error on the calibration parameters.

5. Method according to claim 4, wherein, during step (e), said parameter representative of an error on the calibration parameters is a function of the value of said second expression calculated for the determined values of the calibration parameters.

6. Method according to one of claims 1 to 5, wherein the step (c) comprises determining an accumulated error interval according to the value of said parameter representative of an error on the calibration parameters and of a duration since the last calibration of the gyrometer (11), said predetermined threshold depending on said accumulated error interval.

7. Method according to one of claims 1 to 6, wherein the components of the magnetic field and/or of an i-th derivative of the magnetic field acquired in step (a) are measured components, and those used by the first magnetic equation or equations and the second magnetic equation or equations, are estimated components as a function of the measured components and of calibration parameters of the magnetic measuring means (20), the step (b) and the step (d) also comprising the determining of values of at least one calibration parameter of the magnetic measuring means (20).

8. Method according to claim 7, wherein the magnetic measuring means (20) are tri-axes magnetometers, the estimated components $M^{(estimation)}$ of the magnetic field being linked to the measured components $M^{(measurement)}$ by a model $M^{(measurement)} = A \cdot M^{(estimation)} + b_{magneto}$, where $A$ and $b_{magneto}$ are the calibration parameters of the magnetic measuring means (20).

9. Method according to one of claims 1 to 8, wherein the first magnetic equation or equations are of the form

$$\nabla_n \dot{M} = f_n(\omega) \times \nabla_n M$$ , and the second magnetic equation or equations are of the form

$$\nabla_n \dot{M} = f_n(\omega) \times \nabla_n M + g_n(\nabla_{n+1} M).V,$$ where $\nabla_n M$ is an n-th derivative of the magnetic field, $\omega$ the angular velocity, $V$ the linear velocity, and $f_n$ and $g_n$ predetermined functions.

10. Method according to claim 9, wherein the first expression is a function of

$$\nabla_n \dot{M}^{(estimation)} - f_n\left(\omega_{gyro}^{(estimation)}\right) \times \nabla_n M^{(estimation)}$$ and the second expression is a function of

$$\nabla_n \dot{M}^{(estimation)} - f_n\left(\omega_{gyro}^{(estimation)}\right) \times \nabla_n M^{(estimation)} - g_n(\nabla_{n+1} M^{(estimation)}).V.$$

11. Method according to one of claims 5 and 10 in combination, wherein said parameter representative of an error on the calibration parameters is either the mean of

$$\left|\nabla_n \dot{M}^{(estimation)} - f_n\left(\omega_{gyro}^{(estimation)}\right) \times \nabla_n M^{(estimation)}\right|^2$$ or

$$\left|\nabla_n \dot{M}^{(estimation)} - f_n\left(\omega_{gyro}^{(estimation)}\right) \times \nabla_n M^{(estimation)} - g_n(\nabla_{n+1} M^{(estimation)}).V\right|^2$$ over a given time interval, or all or a portion of a spatial gradient of said components of the magnetic field and/or of an i-th derivative of the magnetic field.

12. Method according to one of claims 1 to 11, comprising a step (f) of estimating, by the data processing means (21), the movement of said object (1) according to the measured angular velocity of the object (1), the components of the magnetic field and/or of an i-th derivative of the magnetic field, and/or of any measured linear velocity of the object (1), and of values of calibration parameters, wherein an orientation of the object (1) is estimated in step (f) only as a function of the measured angular velocity of the object (1) and of values of the calibration parameters.

13. Object (1) moving in an ambient magnetic field, comprising a gyrometer (11) configured to acquire a measured angular velocity of the object (1), magnetic measuring means (20) configured to acquire at least two components of the magnetic field and/or of an i-th derivative of the magnetic field, additional acquisition means (10) configured to acquire a measured linear velocity of the object (1), the object (1) further comprising data processing means (21) configured to:

- determine values of at least one calibration parameter of the gyrometer (11) minimising a first expression defined by an estimated angular velocity of the object (1) and at least one first magnetic equation on the components of the magnetic field and/or of an i-th derivative of the magnetic field,

◦ the estimated angular velocity of the object (1) being a function of the measured angular velocity and of calibration parameters of the gyrometer (11), and
◦ the at least one first magnetic equation assuming that the magnetic field is uniform and stationary around the magnetic measurement means (20);

- estimate a parameter representative of an error on the calibration parameters;

the object being **characterized in that** the data processing means (21) are furthermore configured to:

- if said parameter representative of an error is greater than a predetermined threshold, re-determine values of at least one calibration parameter of the gyrometer (11) minimising a second expression defined by the estimated angular velocity of the object (1) and at least one second magnetic equation on the measured linear velocity and on the components of the magnetic field and/or of an i-th derivative of the magnetic field, the at least one second magnetic equation assuming only that the magnetic field is stationary around the magnetic measurement means (20).

14. Computer program product comprising code instructions for the execution of a method for calibrating a gyrometer (11) according to one of claims 1 to 12, when said program is executed on a computer.

**FIG. 1**

(a)

Acquisition de $M^{(mesure)}$, $\omega_{gyro}^{(mesure)}$ et $V$

(b)

Détermination des valeurs des paramètres de calibration minimisant la première équation magnétique

(c)

Première estimation d'un paramètre représentatif d'une erreur sur les paramètres de calibration

Calibration avec les valeurs déterminées

OUI ← < seuil?

NON

(d)

Détermination des valeurs des paramètres de calibration minimisant la deuxième équation magnétique

Deuxième estimation d'un paramètre représentatif d'une erreur sur les paramètres de calibration

(e)

OUI < seuil? NON

Perturbation magnétique

FIG. 2

## RÉFÉRENCES CITÉES DANS LA DESCRIPTION

**Documents brevets cités dans la description**

- US 20120116716 A
- US 20040123474 A
- FR 1757082
- US 20110178707 A
- US 2012259572 A1
- FR 2939514
- FR 1756675

**Littérature non-brevet citée dans la description**

- **E. DORVEAUX** ; **D. VISSIÈRE** ; **A. P. MARTIN** ; **N. PETIT,**. Iterative calibration method for inertial and magnetic sensors. *Proc. of the 48th IEEE Conf. on Decision and Control*, 2009
- **C.-I. CHESNEAU** ; **M. HILLION** ; **C. PRIEUR**. Motion estimation of a Rigid Body with an EKF using Magneto-Inertial Measurements. *7th Conf. on Indoor Positioning and Indoor Navigation (IPIN'16), Madrid, Spain*, 2016